# EUROPÄISCHE PATENTANMELDUNG

(11) **EP 4 729 905 A1**
(43) Veröffentlichungstag der Anmeldung: **22.04.2026**
(21) Anmeldenummer: 25202686.9
(22) Anmeldetag: 17.09.2025
(51) Int. Cl.: G01K 7/16, G01D 11/00, G01F 1/68, G01N 25/00, G01R 1/36, H01T 4/00, H01T 4/10, H02H 9/06

(54) **SENSORELEMENT MIT ÜBERSPANNUNGSSCHUTZ**

(30) Priorität: 21.10.2024 DE 102024130465
(71) Anmelder: Innovative Sensor Technology IST AG, 9642 Ebnat-Kappel (CH)
(72) Erfinder: Sieben-Xu, Ling, 9652 Neu St. Johann (CH); Barb, Yannick, 9642 Ebnat-Kappel (CH); Schneider, Livia, 9630 Wattwil (CH); Müller, Melanie, 9630 Wattwil (CH); Schläpfer, Julia, 9642 Ebnat-Kappel (CH)
(74) Vertreter: Endress + Hauser Group Services (Deutschland) AG+Co. KG

(57) **Zusammenfassung**

Die Erfindung betrifft ein Sensorelement (1), umfassend:
- Ein Trägerelement (110);
- Eine auf dem Trägerelement (110) aufgebrachte oder angebrachte Sensorstruktur (120) zum Erfassen Messgröße, wobei die Sensorstruktur (120) einen ersten elektrischen Kontaktierungspunkt (121) und einen zweiten elektrischen Kontaktierungspunkt (122) aufweist, wobei die Sensorstruktur (120) durch Anlegen einer Spannung zwischen dem ersten elektrischen Kontaktierungspunkt (121) und dem zweiten elektrischen Kontaktierungspunkt (122) betreibbar ist; und
- Ein auf dem Trägerelement (110) aufgebrachtes Überspannungsschutzelement (130), umfassend ein Teilelementepaar, bestehend aus einem ersten Teilelement und einem zweites Teilelement, wobei das erste Teilelement eine erste Leiterbahn (131) und ein erstes Pad (132) umfasst, wobei das zweite Teilelement eine zweite Leiterbahn (133) und ein von dem ersten Pad (132) beanstandetes zweites Pad (134) umfasst, wobei die erste Leiterbahn (131) den ersten elektrischen Kontaktierungspunkt (121) mit dem ersten Pad (132) elektrisch verbindet, wobei die zweite elektrische Leiterbahn (133) den zweiten elektrischen Kontaktierungspunkt (122) mit dem zweiten Pad (134) verbindet, wobei das erste Pad (132) und das zweite Pad (134) derart ausgestaltet und mit einem ersten Abstand (d1) zueinander auf dem Trägerelement (110) angeordnet sind, dass eine Funkenstrecke zwischen dem ersten Pad (132) und dem zweiten Pad (134) ausgebildet ist.

## Beschreibung

Die Erfindung betrifft ein Sensorelement.

Aus dem Stand der Technik sind zahlreiche Sensorelemente zur Bestimmung von physikalischen, chemischen und/oder biologischen Messgrößen eines Messmediums oder der Umgebung bekannt.

Beispielsweise sind Temperatursensoren zur Erfassung der Temperatur eines Messmediums bekannt. Diese werden bspw. in Dünnschichttechnik, bzw. Dickschichttechnik gefertigt und weisen auf einem Substrat eine funktionale, bzw. funktionale Schicht, bspw. aus Platin, auf. Mittels dieser funktionalen Schicht lässt sich die Temperatur eines Mediums, mit dem die funktionale Schicht in thermischer Wechselwirkung steht, bestimmen. Das Messmedium ist hierbei ein insbesondere gasförmiges oder flüssiges Fluid.

Als weiteres Beispiel seien thermische Strömungssensoren genannt, welche typischerweise aus einem oder mehreren Temperatursensoren und mindestens einem Heizelement bestehen.

Weitere Beispiele für Sensorelemente sind Feuchtesensoren, Dehnungssensoren, Gassensoren, Lichtsensoren, etc. Derjenige Teil des Sensorelements, welcher funktional für das Erfassen der Messgrößen ist, wird im Folgenden als Sensorstruktur bezeichnet. Neben der Sensorstruktur weist ein Sensorelement unter anderem ein Trägerelement, bzw. Substrat, Leiterbahnen, Kontaktpads und ggf. elektronische Bauteile und/oder Schaltungen auf.

Alle diese Sensorelemente sind empfindlich gegenüber elektrostatischen Entladungen (ESD). Diese äußern sich in Spannungsdurchschlägen aufgrund hoher Potentialunterschiede. Diese Spannungsdurchschläge erzielen kurzzeitig hohe elektrische Ströme, welche die Komponenten der Sensorelemente, insbesondere die Sensorstrukturen irreversibel beschädigen können.

Ausgehend von dieser Problematik liegt der Erfindung liegt die Aufgabe zugrunde, ein Sensorelement mit einem integrierten Schutz vor Beschädigungen durch elektrostatische Entladungen vorzustellen.

Die Aufgabe wird durch ein Sensorelement gelöst, welches Sensorelement umfasst:
- Ein Trägerelement;
- Eine auf dem Trägerelement aufgebrachte oder angebrachte Sensorstruktur zum Erfassen einer physikalischen, chemischen und/oder biologischen Messgröße, wobei die Sensorstruktur einen ersten elektrischen Kontaktierungspunkt und einen zweiten elektrischen Kontaktierungspunkt aufweist, wobei die Sensorstruktur durch Anlegen einer Spannung zwischen dem ersten elektrischen Kontaktierungspunkt und dem zweiten Kontaktierungspunkt elektrischen Kontaktierungspunkt betreibbar ist; und
- Ein auf dem Trägerelement aufgebrachtes Überspannungsschutzelement, umfassend ein Teilelementepaar, bestehend aus einem ersten Teilelement und einem zweites Teilelement, wobei das erste Teilelement eine erste Leiterbahn und ein erstes Pad umfasst, wobei das zweite Teilelement eine zweite Leiterbahn und ein von dem ersten Pad beanstandetes zweites Pad umfasst, wobei die erste Leiterbahn den ersten elektrischen Kontaktierungspunkt mit dem ersten Pad elektrisch verbindet, wobei die zweite elektrische Leiterbahn den zweiten elektrischen Kontaktierungspunkt mit dem zweiten Pad verbindet, wobei das erste Pad und das zweite Pad derart ausgestaltet und mit einem ersten Abstand zueinander auf dem Trägerelement angeordnet sind, dass eine Funkenstrecke zwischen dem ersten Pad und dem zweiten Pad ausgebildet ist.

Das erfindungsgemäße Sensorelement weist eine integrierte Struktur in Gestalt eines Überspannungselements auf, welches parallel zu der Sensorstruktur geschaltet ist. Das Überspannungselement besteht im Kern aus einer Funkenstrecke, welche zwischen zwei Pads ausgestaltet ist. Dadurch wird ein zuverlässiger ESD-Schutz erzielt.

Anstatt einer Spannung kann äquivalent auch ein Strom oder eine Leistung zum Betreiben der Sensorstruktur angelegt werden.

Eine Ausgestaltung des Sensorelements sieht vor, dass das erste Pad und das zweite Pad derart angeordnet sind, dass bei Vorliegen einer Spannung zwischen dem ersten Kontaktierungspunkt und dem zweiten Kontaktierungspunkt, welche einen ersten Schwellenwert überschreitet, elektrischer Strom parallel zu der Sensorstruktur über das Überspannungsschutzelement abgeleitet wird. Es ist hierbei vorgesehen, dass der Schwellenwert mehrere kV beträgt. Unterhalb des Schwellenwerts erzeugt die anliegende (Betriebs-)Spannung einen gewünschten Strom, mittels welchem das Sensorelement betrieben wird und welcher zum Ermitteln der Messgröße benötigt wird. Elektrostatische Entladungen verursachen kurzzeitigen Spannungen, welche ein Vielfaches höher als die typischen Betriebsspannungen (welche bspw. 5 V betragen) liegen. Bei Vorliegen einer Spannung höher als der Schwellenwert wird die Luftstrecke zwischen den Pads des Überspannungsschutzes ionisiert, so dass der hohe Entladungsstrom über diese ionisierte Luftstrecke abfließt und dadurch die parallel geschaltete Sensorstruktur nicht beschädigt.

Die Höhe des Schwellenwerts wird insbesondere über die Länge der Funkenstrecke, also dem Abstand des zweiten Pads von dem ersten Pad, definiert. Allgemein gesprochen definiert eine größere Länge einen höheren Schwellenwert.

Gemäß einer Weiterbildung des Sensorelements ist es vorgesehen, dass das Überspannungsschutzelement ein oder mehrere weitere Teilelementepaare, jeweils umfassend ein weiteres erstes Teilelemente, mit jeweils einem weiteren ersten Pad und einer weiteren ersten Leiterbahnen und ein weiteres zweites Teilelement, mit jeweils einem weiteren zweiten Pad und einer weiteren zweiten Leiterbahn, wobei jeweils die weiteren ersten elektrischen Leiterbahnen den zweiten elektrischen Kontaktierungspunkt mit dem entsprechenden weiteren ersten Pad verbinden, wobei jeweils die weiteren zweiten elektrischen Leiterbahnen den zweiten elektrischen Kontaktierungspunkt mit dem entsprechenden weiteren zweiten Pad verbinden, wobei die weiteren ersten Pads und die weiteren zweiten Pads derart ausgestaltet und mit jeweils einem weiteren Abstand zueinander auf dem Trägerelement angeordnet sind, dass jeweils eine weitere Funkenstrecke zwischen dem entsprechenden ersten weiteren Pad und dem entsprechenden weiteren zweiten Pad ausgebildet ist.

Hierbei kann es vorgesehen sein, dass im Falle, dass mehrere weitere Teilelementepaare vorgesehen sind, die weiteren Abstände zueinander und zum ersten Abstand verschieden sind.

Der weitere Abstand, bzw. die weiteren Abstände, definieren hierbei jeweils weitere Schwellenwerte für die anliegende Spannung.

Auf diese Art und Weise können mehrere Schutzlevel vorgesehen werden, welche gegen verschiedene Überspannungsstärken wirken.

Eine vorteilhafte Ausgestaltung des Sensorelements sieht vor, dass das erste Pad und das zweite Pad mitsamt dem dazwischenliegenden Abstand und/oder das weitere erste Pad und das weitere zweite Pad, bzw. die weiteren ersten Pads und die weiteren zweiten Pads, mitsamt den entsprechenden weiteren Abständen, von einer Schicht aus einem dielektrischen Material bedeckt sind. Mittels dieses Materials lässt sich der Schwellenwert beeinflussen, bzw. einstellen. Beispielsweise erzeugt ein Bedecken der Luftstrecke mit Glas einen höheren Schwellenwert. Umgekehrt lässt sich durch das Bedecken der Luftstrecke bei gleichbleibendem Schwellenwert der benötigte Abstand zwischen den Pads beeinflussen.

Gemäß einer ersten Variante ist es vorgesehen, dass das Trägerelement ein Substrat aus einem metallischen Material, keramischen Material oder Halbleitermaterial ist, welches Substrat insbesondere planar ausgestaltet ist. Die Sensorstruktur kann hierbei mittels eines Dickschicht- oder Dünnschichtverfahrens auf das Trägerelement aufgebracht sein.

Als Dünnschichtverfahren eignen sich PVD- oder CVD-Verfahren. Das Material der Sensorstruktur ist hierbei insbesondere ein Metall, beispielsweise Platin im Falle eines Temperatursensors. Als Dickschichtverfahren eignet sich beispielsweise ein Siebdruckverfahren, bei welchem das Material für die Sensorstruktur initial pastenförmig vorliegt und ein Metall oder eine leitfähige Keramik umfasst. Nach dem Bedrucken muss die Sensorstruktur thermisch behandelt, beispielsweise erhitzt, werden, um die flüssigen Bestandteile der Paste zu entfernen.

Gemäß einer zweiten Variante ist es vorgesehen, dass das Trägerelement eine Leiterplatte ist. Die Sensorstruktur kann dann ein elektronisches Bauteil sein, insbesondere ein SMD- oder THT-Bauteil.

Eine vorteilhafte Ausgestaltung des Sensorelements sieht vor, dass das Überspannungsschutzelement mittels eines Dickschicht- oder Dünnschichtverfahrens auf das Trägerelement aufgebracht ist. Im Falle, dass die Sensorstruktur ebenfalls mittels eines Dickschicht- oder Dünnschichtverfahrens aufgebracht ist, können die Sensorstruktur und das Überspannungsschutzelement in einem gemeinsamen Prozessschritt gefertigt werden.

Gemäß einer Ausgestaltung des Sensorelements ist es vorgesehen, dass das Überspannungsschutzelement und die Sensorstruktur auf einer gemeinsamen Seite des Trägerelements aufgebracht, bzw. angebracht, sind. Alternativ kann es vorgesehen sein, das Überspannungsschutzelement und die Sensorstruktur auf verschiedenen Seiten des Trägerelements auf-, bzw. anzubringen.

Die Erfindung wird anhand der nachfolgenden Figuren näher erläutert. Es zeigen
Fig. 1: eine erste Ausführungsform des erfindungsgemäßen Sensorelements;
Fig. 2: eine zweite Ausführungsform des erfindungsgemäßen Sensorelements;
Fig. 3: eine dritte Ausführungsform des erfindungsgemäßen Sensorelements;
Fig. 4: eine vierte Ausführungsform des erfindungsgemäßen Sensorelements; und
Fig. 5: eine fünfte Ausführungsform des erfindungsgemäßen Sensorelements.

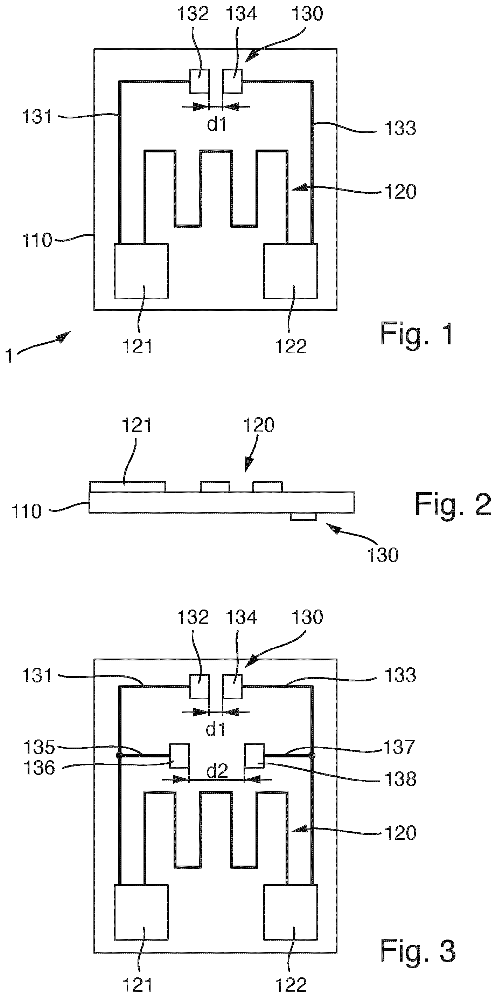

Fig. 1 zeigt eine erste beispielhafte Ausführungsform des erfindungsgemäßen Sensorelements 1 in Draufsicht auf das Sensorelement 1. Das Sensorelement 1 besteht aus einem Trägerelement 110 in Gestalt eines planaren Substrats. Das Substrat ist beispielsweise aus einem keramischen Material gefertigt.

Auf das Trägerelement 110 ist eine Sensorstruktur 120 mit einem ersten elektrischen Kontaktierungspunkt 121 in Gestalt eines Kontaktpads und einem zweiten elektrischen Kontaktierungspunkt 122 in Gestalt eines Kontaktpads aufgebracht. Die Sensorstruktur 120 mit den beiden Kontaktierungspunkten 121, 122 besteht aus einem metallischen Material, insbesondere Platin, und ist im vorliegenden Fall mittels eines Sputter- oder eines Siebdruckverfahrens auf dem Trägerelement 110 aufgebracht.

Die Sensorstruktur 120 dient zum Erfassen einer Temperatur. Hierfür weist die Sensorstruktur 120 einen mäanderförmigen Abschnitt mit einem dünnen Querschnitt auf. Durch Beaufschlagen einer elektrischen Spannung oder eines Stroms zwischen den beiden Kontaktierungspunkten 121, 122 lässt sich der elektrische Widerstand des mäanderförmigen Abschnitts erfassen. Da dieser temperaturabhängig ist, kann somit die Temperatur der Umgebung oder eines Mediums bestimmt werden.

In diesem und den nachfolgenden Ausführungsbeispielen wird ein Temperatursensor beschrieben. Es lassen sich jedoch auch beliebige weitere Arten von Sensorstrukturen verwenden, solange diese mittels zweier oder mehrerer Kontaktpunkte 121, 122 mit elektrischer Spannung beaufschlagt werden können. Es kann auch vorgesehen sein, ein elektronisches Bauteil, bspw. eine Diode oder ein Transistor, als Sensorstruktur 120 vorzusehen.

Zum Schutz der sensiblen Sensorstruktur 120 vor elektrostatischen Entladungen ist ein Überspannungsschutzelement 130 auf das Trägerelement 110 aufgetragen. Das Überspannungsschutzelement 130 besteht aus einem ersten Teilelement mit einem ersten Pad 132 und einer das erste Pad 132 mit dem ersten Kontaktierungspunkt 121 verbindenden ersten elektrischen Leiterbahn 131, sowie aus einem zweiten Teilelement mit einem zweiten Pad 134 und einer das zweite Pad 134 mit dem zweiten Kontaktierungspunkt 122 verbindenden zweiten elektrischen Leiterbahn 133.

Das Überspannungsschutzelement 130 kann aus demselben Material wie die Sensorstruktur 120 bestehen und im selben Prozessschritt mittels desselben Verfahrens auf dem Trägersubstrat 110 aufgetragen sein.

Das erste Teilelement und das zweite Teilelement sind derart angeordnet, dass die beiden Pads 132, 134 einen ersten Abstand d1 zueinander aufweisen, d.h. die beiden Pads 132, 134 berühren sich nicht. Dadurch wird eine sogenannte Funkenstrecke zwischen den beiden Pads 132, 134 ausgebildet. Das bedeutet, dass bei Anliegen einer geringen elektrischen Spannung kein Strom vom ersten Kontaktierungspunkt 121 zum zweiten Kontaktierungspunkt 122 fließt. Erst bei Überschreiten eines ersten Schwellenwerts kommt es zu einem Überschlag von dem ersten Pad 132 zu dem zweiten Pad, wodurch elektrischer Strom parallel zur Mäanderstruktur über das Überspannungsschutzelement 130 abfließt.

Tabelle 1, siehe unten, zeigt mögliche Dimensionierungen und Beispielschwellenwerte. Im vorliegenden Fall beträgt der erste Abstand zwischen den Pads 132, 134 200 µm. Der erste Schwellenwert beträgt daher 4 kV.

Auf diese Art und Weise wird ein einfacher und zuverlässiger Schutz vor Überspannungen für das Sensorelement 1 geschaffen, welcher sich direkt mit der Sensorstruktur 120 auf einem gemeinsamen Trägerelement 110 integrieren lässt.

Fig. 2 zeigt ein zweites Ausführungsbeispiel des Sensorelements 1 als Querschnitt. Die Dimensionierungen der Elemente des Sensorelements 1 entsprechenden grundlegend denen des Sensorelements des in Fig. 1 gezeigten Ausführungsbeispiels. Das Überspannungsschutzelement 130 ist hier aber nicht auf derselben Seite des Trägerelements 110 aufgetragen, sondern befindet sich auf der der Sensorstruktur 120 gegenüberliegenden Seite des Substrats 110. Die jeweiligen Leiterbahnen 131, 133 kontaktieren die entsprechenden Kontaktierungspunkte 121, 122 hierbei mittels Durchkontaktierungen (Through Holes) durch das Trägerelement 110.

Fig. 3 zeigt ein drittes Ausführungsbeispiel des Sensorelements 1 als Draufsicht. Die Dimensionierungen der Elemente des Sensorelements 1 entsprechenden grundlegend denen des Sensorelements des in Fig. 1 gezeigten Ausführungsbeispiels. Das Überspannungsschutzelement 130 ist in diesem Ausführungsbeispiel allerdings erweitert: Zusätzlich zu dem ersten und dem zweiten Teilelement sind zwei weitere Teilelemente vorhanden. Dadurch ist ein drittes Pad 136 und ein viertes Pad 138 vorgesehen, welche jeweils mittels weiterer Leiterbahnen 135, 137 mit den entsprechenden Kontaktierungspunkten 121, 122 verbunden sind. Hierbei können die erste Leiterbahn 131 und die weitere erste Leiterbahn 135 zumindest abschnittsweise zusammengefasst sein, sowie die zweite Leiterbahn 131 und die weitere zweite Leiterbahn 137 zumindest abschnittsweise zusammengefasst sein.

Das weitere erste Pad 136 weist einen zweiten Abstand d2 zu dem weiteren zweiten Pad 138 auf. Dadurch wird ein weiterer Schwellenwert für die Überspannung vorgesehen. Tabelle 1, siehe unten, zeigt mögliche Dimensionierungen und Beispielschwellenwerte. Im vorliegenden Fall beträgt der erste Abstand d1 zwischen den Pads 132, 134 200 µm. Der erste Schwellenwert beträgt daher 4 kV. Der weitere Abstand d2 zwischen den Pads 136, 138 beträgt 300 µm. Der weitere Schwellenwert beträgt daher 8 kV.

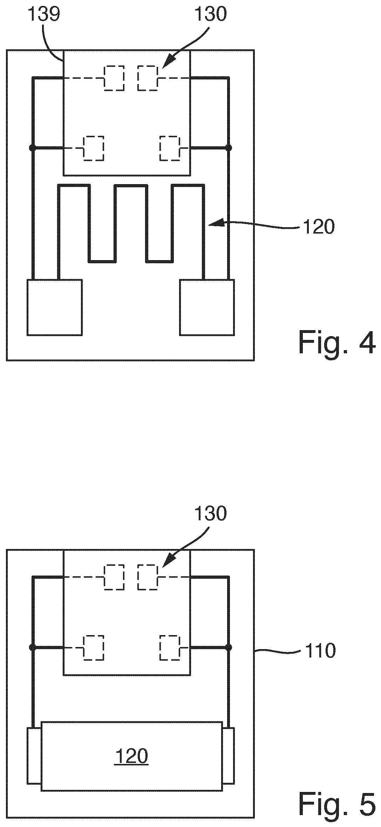

Fig. 4 zeigt ein viertes Ausführungsbeispiel des Sensorelements 1 als Draufsicht. Die Dimensionierungen der Elemente des Sensorelements 1 entsprechenden grundlegend denen des Sensorelements des in Fig. 2 gezeigten Ausführungsbeispiels. Es wird hier zusätzlich eine Schicht 139 aufgesehen, welche über den Pads 132, 134, 136, 138 und die jeweilige zwischen den Pads 132, 134, 136, 138 ausgebildete Funkenstrecke aufgetragen ist. Die Schicht 139 besteht aus einem dielektrischen Material und ist mittels eines Dickschicht- oder Dünnschichtverfahrens aufgebracht.

Das dielektrische Material bewirkt, dass der jeweilige Schwellenwert der Funkenstrecke beeinflusst wird. Durch Wahl des Materials lässt sich der Schwellenwert so gezielt wählen. Entsprechend kann bei gleichbleibendem Schwellenwert der Abstand zwischen den Pads 132, 134, 136, 138 beeinflusst werden.

Im vorliegenden Beispiel wird ein Glas als dielektrisches Material gewählt. Tabelle 1, siehe unten, zeigt mögliche Dimensionierungen und Beispielschwellenwerte für diesen Fall. Im vorliegenden Fall beträgt der erste Abstand d1 zwischen den Pads 132, 134 5 µm. Der erste Schwellenwert beträgt, da eine Schicht 139 aus Glas vorhanden ist, 3 kV. Der weitere Abstand d2 zwischen den Pads 136, 138 beträgt 10 µm. Der weitere Schwellenwert beträgt, da eine Schicht 139 aus Glas vorhanden ist, 4 kV.

Fig. 4 zeigt ein viertes Ausführungsbeispiel des Sensorelements 1 als Draufsicht. Die Dimensionierungen der Elemente des Sensorelements 1 entsprechenden grundlegend denen des Sensorelements des in Fig. 2 gezeigten Ausführungsbeispiels. Das Substrat wird hier durch eine Leiterplatte als Trägerelement 110 ersetzt. Die Sensorstruktur 120 ist hier als elektronisches Bauteil (Temperatursensor mit Gehäuse) ausgestaltet, welches auf die Kontaktierungspunkte 121, 122 gelötet ist. Das Überspannungsschutzelement 130 ist entsprechend der vorherigen Beispiele beschrieben aufgebracht. Die Abstände d1, d2 und Schwellenwerte entsprechen denen des bezüglich Fig. 4 aufgeführten Ausführungsbeispiels.

**Tabelle 1**

| **Abstand (d1, d2)** | **Dieelektrisches Material** | **Schwellenwert** |
|---|---|---|
| 5 µm | Glas | 3 kV |
| 10 µm | Glas | 4 kV |
| 300 µm | n.a. (Luft) | 8 kV |
| 200 µm | n.a. (Luft) | 4 kV |

### Bezugszeichenliste

- 1: Sensorelement
- 110: Trägerelement
- 120: Sensorstruktur
- 121, 122: elektrische Kontaktierungspunkte
- 130: Überspannungsschutzelement
- 131: erste Leiterbahn
- 132: erstes Pad
- 133: zweite Leiterbahn
- 134: zweites Pad
- 139: Schicht aus dielektrischem Material
- d1: erster Abstand
- d2: weiterer Abstand

## Patentansprüche

1. Sensorelement (1), umfassend:
- Ein Trägerelement (110);
- Eine auf dem Trägerelement (110) aufgebrachte oder angebrachte Sensorstruktur (120) zum Erfassen einer physikalischen, chemischen und/oder biologischen Messgröße, wobei die Sensorstruktur (120) einen ersten elektrischen Kontaktierungspunkt (121) und einen zweiten elektrischen Kontaktierungspunkt (122) aufweist, wobei die Sensorstruktur (120) durch Anlegen einer Spannung zwischen dem ersten elektrischen Kontaktierungspunkt (121) und dem zweiten elektrischen Kontaktierungspunkt (122) betreibbar ist; und
- Ein auf dem Trägerelement (110) aufgebrachtes
Überspannungsschutzelement (130), umfassend ein Teilelementepaar, bestehend aus einem ersten Teilelement und einem zweites Teilelement, wobei das erste Teilelement eine erste Leiterbahn (131) und ein erstes Pad (132) umfasst, wobei das zweite Teilelement eine zweite Leiterbahn (133) und ein von dem ersten Pad (132) beanstandetes zweites Pad (134) umfasst, wobei die erste Leiterbahn (131) den ersten elektrischen Kontaktierungspunkt (121) mit dem ersten Pad (132) elektrisch verbindet, wobei die zweite elektrische Leiterbahn (133) den zweiten elektrischen Kontaktierungspunkt (122) mit dem zweiten Pad (134) verbindet, wobei das erste Pad (132) und das zweite Pad (134) derart ausgestaltet und mit einem ersten Abstand (d1) zueinander auf dem Trägerelement (110) angeordnet sind, dass eine Funkenstrecke zwischen dem ersten Pad (132) und dem zweiten Pad (134) ausgebildet ist.

2. Sensorelement nach Anspruch 1, wobei das erste Pad (132) und das zweite Pad (134) derart angeordnet sind, dass bei Vorliegen einer Spannung zwischen dem ersten Kontaktierungspunkt (121) und dem zweiten Kontaktierungspunkt (122), welche einen ersten Schwellenwert überschreitet, elektrischer Strom parallel zu der Sensorstruktur (120) über das Überspannungsschutzelement (130) abgeleitet wird.

3. Sensorelement nach Anspruch 1 oder 2, wobei das Überspannungsschutzelement (130) ein oder mehrere weitere Teilelementepaare, jeweils umfassend ein weiteres erstes Teilelemente, mit jeweils einem weiteren ersten Pad (136) und einer weiteren ersten elektrischen Leiterbahn (135) und ein weiteres zweites Teilelement, mit jeweils einem weiteren zweiten Pad (138) und einer weiteren zweiten elektrischen Leiterbahn (137), wobei jeweils die weiteren ersten elektrischen Leiterbahnen (135) den ersten elektrischen Kontaktierungspunkt (121) mit dem entsprechenden weiteren ersten Pad (136) verbinden, wobei jeweils die weiteren zweiten elektrischen Leiterbahnen (137) den zweiten elektrischen Kontaktierungspunkt (122) mit dem entsprechenden weiteren zweiten Pad (138) verbinden, wobei die weiteren ersten Pads (136) und die weiteren zweiten Pads (138) derart ausgestaltet und mit jeweils einem weiteren Abstand (d2) zueinander auf dem Trägerelement (110) angeordnet sind, dass jeweils eine weitere Funkenstrecke zwischen dem entsprechenden ersten weiteren Pad (136) und dem entsprechenden weiteren zweiten Pad (138) ausgebildet ist.

4. Sensorelement nach Anspruch 3, wobei im Falle, dass mehrere weitere Teilelementepaare vorgesehen sind, die weiteren Abstände (d2) zueinander und zum ersten Abstand (d1) verschieden sind.

5. Sensorelement nach Anspruch 3 oder 4, wobei der weitere Abstand (d2), bzw. die weiteren Abstände, jeweils weitere Schwellenwerte für die anliegende Spannung definieren.

6. Sensorelement nach einem der vorherigen Ansprüche, wobei das erste Pad (132) und das zweite Pad (134) mitsamt dem dazwischenliegenden ersten Abstand (d1) und/oder das weitere erste Pad (136) und das weitere zweite Pad (138), bzw. die weiteren ersten Pads und die weiteren zweiten Pads, mitsamt den entsprechenden weiteren Abständen (d2), von einer Schicht (139) aus einem dielektrischen Material bedeckt sind.

7. Sensorelement nach einem der vorherigen Ansprüche, wobei das Trägerelement (110) ein Substrat aus einem metallischen Material, keramischen Material oder Halbleitermaterial ist, welches Substrat insbesondere planar ausgestaltet ist.

8. Sensorelement nach Anspruch 7, wobei die Sensorstruktur (120) mittels eines Dickschicht- oder Dünnschichtverfahrens auf das Trägerelement (110) aufgebracht ist.

9. Sensorelement nach einem der vorherigen Ansprüche, wobei das Trägerelement (110) eine Leiterplatte ist.

10. Sensorelement nach Anspruch 9, wobei die Sensorstruktur (120) ein elektronisches Bauteil ist, insbesondere ein SMD- oder THT-Bauteil.

11. Sensorelement nach einem der vorherigen Ansprüche, wobei das Überspannungsschutzelement (130) mittels eines Dickschicht- oder Dünnschichtverfahrens auf das Trägerelement (110) aufgebracht ist.

12. Sensorelement nach einem der vorherigen Ansprüche, wobei das Überspannungsschutzelement (130) und die Sensorstruktur (120) auf einer gemeinsamen Seite des Trägerelements (110) aufgebracht, bzw. angebracht, sind.

13. Sensorelement nach einem der Ansprüche 1 bis 11, wobei das Überspannungsschutzelement (130) und die Sensorstruktur (120) auf verschiedenen Seiten des Trägerelements (110) aufgebracht, bzw. angebracht, sind.
